# EUROPÄISCHE PATENTSCHRIFT

(11) **EP 3 970 199 B1**
(45) Veröffentlichungstag und Bekanntmachung des Hinweises auf die Patenterteilung: **28.06.2023**
(21) Anmeldenummer: 20728928.1
(22) Anmeldetag: 15.05.2020
(51) Int. Cl.: H01L 31/02, H02S 40/30, H02S 50/00, H01L 31/042

(54) **VORRICHTUNG ZUR UMWANDLUNG VON LICHT IN ELEKTRISCHE ENERGIE**
APPARATUS FOR CONVERTING LIGHT INTO ELECTRICAL ENERGY
DISPOSITIF DE CONVERSION DE LUMIÈRE EN ÉNERGIE ÉLECTRIQUE

(30) Priorität: 16.05.2019 DE 102019112895
(43) Veröffentlichungstag der Anmeldung: 23.03.2022
(73) Patentinhaber: Deutsches Zentrum für Luft- und Raumfahrt e.V., 51147 Köln (DE)
(72) Erfinder: GRUNDMANN, Jan Thimo, 28237 Bremen (DE); SPIETZ, Peter, 28211 Bremen (DE)
(74) Vertreter: FARAGO Patentanwälte GmbH
(86) Internationale Anmeldenummer: PCT/DE2020/100422
(87) Internationale Veröffentlichungsnummer: WO 2020/228912

(56) Entgegenhaltungen:
- CN-A- 107 579 587
- CN-A- 107 902 110
- US-A- 6 127 621
- US-A1- 2014 183 960
- US-A1- 2018 233 919
- JAW-KUEN SHIAU ET AL: "Design of a Solar Power Management System for an Experimental UAV", IEEE TRANSACTIONS ON AEROSPACE AND ELECTRONIC SYSTEMS, IEEE SERVICE CENTER, PISCATAWAY, NJ, US, Bd. 45, Nr. 4, 1. Oktober 2009 (2009-10-01), Seiten 1350-1360, XP011297109, ISSN: 0018-9251

## Beschreibung

Die Erfindung betrifft eine Vorrichtung zur Umwandlung von Licht in elektrische Energie mittels eines Photovoltaikgenerators, wobei die von der Vorrichtung gelieferte elektrische Spannung ein Niveau aufweist, das verbraucherseitig durch die zu betreibenden Geräte bestimmt ist. Insbesondere betrifft die Erfindung eine solche Vorrichtung, die zum Einsatz auf einem Satelliten geeignet ist. Weiterhin betrifft die Erfindung ein Verfahren zum Betreiben einer solchen Vorrichtung sowie ein Energieerzeugungssystem eines Satelliten.

Unter einem Satelliten wird hier und im Folgenden ein künstlicher Raumflugkörper verstanden. Solche Satelliten können beispielsweise Erdsatelliten, also künstliche Gerätschaften, welche die Erde umkreisen, oder auch Orbiter sein, also künstliche Satelliten, die einen anderen Körper als die Erde umlaufen und erforschen oder zwischen verschiedenen Körpern unterwegs sind oder zwischen Umlaufbahnen pendeln, sowie Lander, die auf die Oberfläche eines solchen Himmelskörpers absteigen, um dort betrieben zu werden. Satelliten können bemannt oder unbemannt sein. Erdsatelliten werden u.a. zum Betrieb von GPS-Systemen und für Kommunikationsanwendungen sowie für Wetterbeobachtungen oder sonstige Informationsaufnahmen eingesetzt. Zur Erledigung dieser vielfältigen Aufgaben benötigen Satelliten Energie. Diese Energie erzeugen die Satelliten üblicherweise selbst, indem sie Vorrichtungen aufweisen, die aus dem Sonnenlicht elektrische Energie erzeugen. Solche Vorrichtungen weisen Photovoltaikgeneratoren auf, die ihrerseits Photovoltaikmodule aufweisen. Dabei weist ein Photovoltaikmodul eine oder mehrere Solarzellen auf, die in Serie oder parallel geschaltet sind. Eine Solarzelle ist ein elektrisches Bauelement, das Strahlungsenergie, in der Regel Sonnenlicht, direkt in elektrische Energie umwandelt. Die physikalische Grundlage der Umwandlung ist der photovoltaische Effekt, bei dem Ladungsträgerpaare, die am p-n-Übergang einer Photodiode, entstehen, in p- und n-Schicht getrennt werden. Dabei gehen die Elektronen in die n-Schicht und die Löcher in die p-Schicht über und es entsteht ein Strom gegen die Durchlassrichtung des Übergangs.

Zum Betrieb von Photovoltaikgeneratoren sind Spannungskonverter erforderlich, die die von den Photovoltaikmodulen, d.h. von gemeinsam in Reihe und/oder parallel geschalteten einzelnen Photovoltaikzellen, gelieferte elektrische Spannung auf das Niveau anheben oder absenken, d.h. konvertieren, die verbraucherseitig durch die zu betreibenden Geräte sowie das dementsprechend gewählte Batterieladesystem bestimmt ist. Eine Photovoltaikzelle ist ein elektrisches Bauelement, das Strahlungsenergie, in der Regel Sonnenlicht, direkt in elektrische Energie umwandelt. Die physikalische Grundlage der Umwandlung ist der photovoltaische Effekt, der ein Sonderfall des inneren photoelektrischen Effekts ist. In der Photovoltaiktechnologie werden u.a. elektronische Bauelemente verwendet. Die von einem Photovoltaikmodul abgegebene Spannung ist von der Halbleitereigenschaft der verwendeten Photovoltaiktechnologie bzw. bei gestapelten Kombination verschiedener Photovoltaiktechnologien in sogenannten Multijunction-Zellen und der Anzahl der in Reihe geschalteten Photovoltaikzellen abhängig, sowie von der Temperatur der Zellen und dem Verhältnis von Intensität der Beleuchtung jeder Photovoltaikzelle zur elektrischen Last. Stand der Technik bei Photovoltaikgeneratoren für Raumfahrtanwendungen sind solche Spannungskonverter, die zentral im Satelliten untergebracht sind. Durch die zentrale Zusammenfassung mehrerer Photovoltaikmodule an einer gemeinsamen Konverterelektronik ist es erforderlich, dass alle Photovoltaikmodule im Nominalfall möglichst die gleiche Spannung liefern. Sie müssen von daher die gleiche Anzahl von Zellen und damit die gleiche Fläche haben. Eine optimierte Flächenausnutzung einer durch z.B. geometrische Randbedingungen eingeschränkten Photovoltaiknutzfläche ist nur sehr eingeschränkt, wenn überhaupt, möglich. Zudem werden selbst gleichartig verschaltete Zellengruppen durch ihre beleuchtungs- und temperaturabhängigen Parameter an unterschiedlichen Orten mit unterschiedlichen Bedingungen auf einem Generator mit unterschiedlichen Abweichungen von ihrem optimalen Betriebspunkt betrieben, woraus sich ein systemischer Zusammenschaltungsverlust ergibt. Weiterhin müssen einzelne Photovoltaikmodule wegen ihrer Zusammenschaltung gegen Kurzschlüsse in ihnen gesichert werden, da ansonsten ein kurzgeschlossenes Modul die von anderen Modulen gelieferte Leistung nutzlos ableitet, bevor sie den zentralen Satellitenkörper erreichen kann. In der Regel muss dieser Schutz auf der niedrigsten Modulebene angebracht sein, einer Reihenschaltung von einzelnen Photovoltaikzellen, "string" genannt. Es wird hier üblicherweise eine String-Schutzdiode verwendet, die nur vom String gelieferten Strom fließen lässt, aber jeden in ihn zurückfließenden Verbrauchsstrom sperrt. Als sperrschichtbasiertes Halbleiterbauteil verbraucht sie ständig in etwa die von einer photovoltaischen Sperrschicht in ihrem String erzeugte Leistung. Beispielsweise erzeugt ein String 10 W. Moderne starre Weltraum-Solarzellen beinhalten je drei generierende Sperrschichten (triple junction). Jede Zelle erzeugt 2.3 V * 0.5 A = 1.15 W. Es werden für die Erzeugung von 10 W also 9 Zellen benötigt, die 20.7 V * 0.5 A = 10.35 W erzeugen. Die Stringdiode hat einen physikalisch bedingten Spannungsabfall von 0.7 V, der durch gleichartige physikalische Umstände dem Spannungsgewinn einer der drei photovoltaischen Sperrschichten in einer Zelle entspricht. Durch die reine Reihenschaltung ist der Strom überall gleich, nämlich 0.5 A. Daher verbraucht die Stringdiode 0.7 V * 0.5 A = 0.35 W. Der String liefert danach 10 W. Damit gehen allein an der Stringdiode bereits 3.5% der vom String erzeugten Leistung verloren. Bei einem 10-kW-Satelliten sind dies 350 W oder die typische Leistung eines größeren Kleinsatelliten wie z.B. EuCROPIS. Höhere Stringspannungen machen den Verlust offensichtlich anteilig kleiner.

Weiterhin ist, abgesehen von erforderlichen Redundanzen, wegen der Baugröße und entsprechend hoher Bauteilmasse in der Regel auch nur ein Spannungskonverter für alle beziehungsweise für eine größere Anzahl von parallel geschalteten Photovoltaikmodulen vorgesehen. Kennzeichnend für den Stand der Technik ist die Quer- oder Parallelverschaltung der Ein- und Ausgänge und dass der Spannungskonverter im Inneren des Satellitenkörpers angeordnet ist. Hierbei ist von Bedeutung, dass gerade bei größeren Photovoltaikgeneratoren eine große Anzahl einzelner Photovoltaikmodule zum Einsatz kommt. Darüber hinaus werden insbesondere Spannungskonverter, die von vergleichsweise niedrigen Photovoltaikmodulspannungen auf höhere Spannungen im Bereich mehrerer Hundert Volt konvertieren, nicht verwendet, da sie ggf. durch Isolationsanforderungen noch größer ausfallen und nach der Topologie diese hohe Spannung auf dem kurzen Weg vom Spannungskonverter zur Batterie und Verbrauchern - allesamt zentral gelegen - keinen spürbaren Vorteil bringt. Die von den Photovoltaikmodulen gelieferte Spannung liegt im Allgemeinen bei maximal ca. 150 V Leerlaufspannung wie bei der Raumstation ISS oder bei 50 bis 110 V im Falle üblicher geostationärer Satelliten. Bei höheren Spannungen im Bereich der Photovoltaikmodule und Photovoltaikzellen ist das Risiko von elektrischen Überschlägen und damit verbundener Zerstörung von Teilen des Generators nicht mehr kontrollierbar. Besonders in niedrigen Umlaufbahnen besteht die Gefahr des selbstgespeisten lawinenartigen Anwachsens einer kleinen anfänglichen Entladung durch das Plasma der umgebenden Restatmosphäre. Der Spannungshub zwischen z.B. 50 V unter optimaler Last bei warmer Photovoltaik und 110 V Leerlaufspannung ohne Last bei kalter Photovoltaik ist physikalisch bedingt und daher unabänderlich. Des Weiteren werden die Spannungskonverter als zentrale Knoten auf hohe Einzelleistung ausgelegt und aufgrund der wiederholten Nutzung der althergebrachten Topologie immer wieder gleich mit vergleichsweise alter, weil bewährter, Elektronik gebaut. Diese älteren Ausführungen der Hochleistungs-Elektronikkomponenten sind von der Bauform her im Vergleich zu moderner Elektronik deutlich größer, was den allgemeinen Eindruck vermittelt, nur eine zentrale Unterbringung sei sinnvoll.

Satelliten müssen wegen der hohen Startkosten möglichst leicht sein. Unnötige Masse muss generell, eben auch bei Photovoltaikgeneratoren und den erforderlichen Stromleitungen, vermieden werden. Darüber hinaus sind Photovoltaikgeneratoren in der Regel ausklappbar. Da die mit dem Gewicht und Abstand vom Schwerpunkt steigende Massenträgheit schädlich hinsichtlich der erforderlichen Lagekontrolle ist, ergibt sich ein weiterer Grund für Masseeinsparung bei den Photovoltaikgeneratoren sowie zur Minimierung ihrer Größe. Schwerere oder größere Photovoltaikgeneratoren erfordern leistungsfähigere Lagekontrollsysteme, was wiederum höhere Kosten verursacht. Alle dauerhaft verwendeten Lageregelungsaktuatoren benötigen wiederum elektrische Energie proportional zur aufzubringenden Kraft.

CN 107 902 110 A offenbart ein hochintegriertes standardisiertes MPPT-Modul mit offener Architektur umfassend eine Vielzahl von standardisierten MPPT-Submodulen. Jedes standardisierte MPPT-Submodul enthält eine DC/DC-Schaltung, eine Trenndiode, eine Schutzdiode, einen positiven Eingangsanschluss, einen negativen Eingangsanschluss, einen positiven Ausgangsanschluss und einen negativen Ausgangsanschluss. Die MPPT-Standardmodultopologie, die durch das offene Gerüst des hochintegrierten MPPT-Standardmoduls bereitgestellt wird, ist offen im Sinne eines Allzweck-Baustein, Modi wie Eingang parallel und Ausgang in Reihe, parallel oder parallel-seriell können durch die Verbindung verschiedener Eingangs- und Ausgangsanschlüsse der MPPT-Standarduntermodule erreicht werden, dabei werden jeweils in Baustein-Abstufungen flexibel die Ausgangsspannung und/oder der Ausgangsstrom erhöht und somit die Ausgangsleistung erweitert. Das hochintegrierte MPPT-Standardmodul mit offener Architektur ist angepasst sich an die schnelle Montage und die flexiblen Entwicklungsanforderungen von durchstandardisierten Mikro- oder Nano-Satelliten-Plattformen für vielfältige Aufgaben; durch den Modus von Eingang parallel + Ausgang seriell und parallel oder seriell-parallel wird das Konsistenzproblem gelöst, das durch die übermäßige Anzahl oder Vielfalt von Reihenschaltungen traditioneller Eingangssolarzellen verursacht wird, und die Tracking-Genauigkeit des MPPT wird bezogen auf diesen abgestuft modularisierten flexiblen Einsatz von Standardmodulen verbessert, und die Nutzungsrate der Solarzellen-Array-Energie wird verbessert.

Aufgabe der Erfindung ist es, eine Vorrichtung zur Umwandlung von Licht in elektrische Energie insbesondere für einen Satelliten anzugeben, die für eine gegebene Ausgangsleistung eine signifikant kleinere Masse als bekannte Vorrichtungen aufweist. Weiterhin ist es Aufgabe der Erfindung, ein Verfahren zum Betreiben einer solchen Vorrichtung anzugeben, mit dem die Effizienz der Vorrichtung optimiert ist. Daneben ist es Aufgabe der Erfindung, ein Energieerzeugungssystem eines Satelliten anzugeben, das eine signifikant kleinere Masse als bekannte Energieerzeugungssysteme gleicher Leistung aufweist.

Erfindungsgemäß wird diese Aufgabe durch eine Vorrichtung mit den Merkmalen des unabhängigen Anspruches 1 gelöst. Vorteilhafte Weiterbildungen der Vorrichtung ergeben sich aus den Unteransprüchen 2-6. Die Aufgabe wird ferner durch ein Verfahren nach Anspruch 7 gelöst. Eine vorteilhafte Ausführungsform des Verfahrens ergibt sich aus Unteranspruch 8. Darüber hinaus wird die Aufgabe durch ein Energieerzeugungssystem gemäß Anspruch 9 gelöst. Vorteilhafte Ausführungsformen des Energieerzeugungssystems ergeben sich aus den Unteransprüchen 10 und 11.

Eine erfindungsgemäße Vorrichtung zur Umwandlung von Licht in elektrische Energie für einen Satelliten weist einen oder mehrere Cluster auf, wobei ein Cluster aus einem einzelnen Photovoltaikmodul oder einer Reihenschaltung einzelner Photovoltaikmodule oder einer Parallelschaltung einzelner Photovoltaikmodule oder einer Parallelschaltung von Reihenschaltungen aus einzelnen Photovoltaikmodulen oder einer Reihenschaltung von Parallelschaltungen aus einzelnen Photovoltaikmodulen besteht. Ein Photovoltaikmodul besteht aus einer einzelnen Photovoltaikzelle oder einer Reihenschaltung einzelner Photovoltaikzellen oder einer Parallelschaltung einzelner Photovoltaikzellen oder einer Parallelschaltung von Reihenschaltungen aus einzelnen Photovoltaikzellen oder einer Reihenschaltung von Parallelschaltungen aus einzelnen Photovoltaikzellen. Die genannten Schaltungsmöglichkeiten werden im Folgenden unter dem Begriff Verschaltung zusammengefasst.

Der Photovoltaikgenerator kann auf ein oder mehrere Solarpaneele aufgeteilt sein, wobei der Teilbegriff 'Paneel' hier keine besondere Bauart bezeichnet, sondern breit zu verstehen ist und jede Vorrichtung bezeichnet, die ein oder mehrere Cluster tragen kann. Insbesondere muss ein Paneel nicht starr sein, sondern kann auch mechanisch flexibel ausgeführt sein. Beispiele für ein flexibel ausgeführtes Paneel sind membran- oder blanketbasierte Trägersysteme. Durch die dezentrale Anordnung der Cluster inklusive Spannungskonverter sind kurze Leitungswege der Niederspannung an der Eingangsseite möglich, womit Leistungsverluste minimiert werden. Weiterhin ist die unmittelbare Messung der Arbeitsbedingungen und direkte optimale Regelung des sich daraus ergebenden Arbeitspunktes für maximalen Ertrag jedes einzelnen Clusters möglich.

Ein Cluster ist in der Regel auf nur einem Solarpaneel verortet. Jedem Cluster ist ein Spannungskonverter zugeordnet. Auch dieser eine Spannungskonverter, der äußerlich als ein funktionales Bauteil mit funktional je einem Ein- und Ausgang anzusehen ist, kann, wie bereits beim zentralen Spannungskonverter beschrieben, innerlich aus mehreren Schaltkreisen bestehen, um beispielsweise eine Redundanz zu erzeugen. Insbesondere kann jedem Cluster genau ein Spannungskonverter zugeordnet sein. Durch die Verwendung von einem Spannungskonverter für jedes Cluster kann der Spannungskonverter kleiner und damit auch leichter ausfallen als bei bekannten Systemen mit einem zentralen Spannungskonverter für mehrere Cluster. Bei einer Zuordnung von genau einem Spannungskonverter zu jedem Cluster können Photovoltaikmodule in von Cluster zu Cluster unterschiedlicher Größe, d.h. mit unterschiedlicher Anzahl von insgesamt in Reihe geschalteten Zellen, verwendet werden, da jedes Cluster einen eigenen Spannungskonverter hat. Damit sind auch unterschiedliche geometrische Größen für Cluster und Photovoltaikmodule möglich, wodurch die Flächenausnutzung auf einem Solarpaneel verbessert wird. Somit ist eine Optimierung durch Anpassung und Abstimmung der Cluster sowie der Photovoltaikmodulgröße auf die verfügbaren Flächen, örtliche und lageabhängige Beleuchtungs- und Temperaturunterschiede innerhalb der verfügbaren Flächen, und die allgemeinen elektrischen Belange möglich. Nur innerhalb des Clusters sollte für optimalen Ertrag jede Teilverschaltung von Solarzellen gleichartig aufeinander abgestimmt sein. Einzelzellen müssen nicht abgestimmt sein. Möglichkeiten zur Abstimmung von Mehrzellencluster sind beispielsweise bei Ein-String-Clustern die Vergleichmäßigung der Lage des Maximum Power Point jeder Zelle zum Strom bei sonst gleichen Bedingungen, wobei die Spannung am Maximum Power Point unterschiedlich sein kann; bei Mehr-String-Clustern oder konventionellen PV-Modul/- Paneelen soll der Maximum Power Point jeder Zelle in jedem String möglichst beim gleichen Strom liegen, wobei dieser Strom kann von String zu String verschieden sein kann, oder die Vergleichmäßigung der gelieferten Spannung aller Strings in ihrem jeweiligen Maximum Power Point. Es hat sich aus Platzeinspargründen als vorteilhaft erwiesen, wenn jedes Cluster zusammen mit dem diesem Cluster zugeordneten Spannungskonverter auf jeweils genau einem Solarpaneel angeordnet ist. Dabei kann ein Cluster auch auf mehrere Solarpaneele aufgeteilt sein.

Das kleinstmögliche Cluster besteht aus einer Solarzelle, der ein Spannungskonverter zugeordnet ist. Die Solarzelle ist dann gleichzeitig das einzige Photovoltaikmodul des Clusters. Mittels der Technologie integrierter Schaltungen ist der Spannungskonverter direkt in eine Photovoltaikzelle integriert. (hierbei spricht man von einem monolithischen Aufbau) oder der Spannungskonverter ist unmittelbar an einer Photovoltaikzelle angeordnet. Hierbei spricht man von einem Hybridaufbau. Eine solche Solarzelle ist dann zugleich Photovoltaikmodul und Cluster inklusive Spannungskonverter. Weiterhin kann die Stromführung vom Konverterausgang eines Clusters zu Batterie und Verbrauchern mit höherer Spannung und niedrigerem Strom erfolgen, wodurch der Einsatz reduzierter Leitungsquerschnitte in der elektrischen Verkabelung ermöglicht wird und die stromproportionalen Leitungsverluste auf dieser Strecke sinken. Darüber hinaus ist die Führung von höheren Spannungen in Größenordnung mehrerer Hundert Volt in geschlossen isolierten reinen Leitungen bezüglich des Überschlagsrisikos im Bereich von Photovoltaikzellen und Photovoltaikmodulen deutlich weniger kritisch als würden diese hohen Spannungen direkt an den zum Weltraum offenen oder nur dünn isolierten (weil Frontseite PV) Verbindungselementen oder Oberflächen der Photovoltaikzellen anliegen.

Es hat sich als vorteilhaft erwiesen, wenn der Spannungskonverter aus modernen Elektronikkomponenten aufgebaut ist. Zu solchen Komponenten zählen beispielsweise integrierte Schaltungen (ICs) oder Module für micro-power- und power-harvesting-Anwendungen, welche bereits auf Leistung und Spannung kleiner Cluster oder einzelner Strings im Stand der Technik optimiert sind und alle nötigen aktiven bzw. alle nötigen aktiven und wesentliche passive Bauteile enthalten, sowie IC-basierte Ladungspumpen für Anwendungen kleinerer Leistung beispielsweise integriert in oder an einer einzelnen Photovoltaikzelle. Durch die Verwendung solcher moderner Elektronikkomponenten ist es möglich, den Spannungskonverter bei der relativ kleinen Leistung eines Clusters und trotz (verhältnismäßig) hoher Ausgangsspannung sehr kompakt und leicht auszuführen, was erst die Unterbringung direkt am Cluster und somit auf dem Solarpaneel ermöglicht, im Extremfall an oder in der Photovoltaikzelle selbst. Die elektrische Spannung im Bereich eines Clusters wird klein gehalten, sodass das Risiko elektrischer Überschläge dort minimiert oder ausgeschlossen wird. Es kann sogar gegenüber herkömmlichen 100 bis 150V-Systemen reduziert werden, da die Photovoltaikspannung im Cluster und am Eingang seines Spannungskonverters klein bleiben kann aufgrund der relativ kleinen Leistung eines Clusters und der geringen Länge der verlustbehafteten Strompfade zur dort direkt angeschlossenen modernen Konverterelektronik. Die dezentrale Nutzung erlaubt durch Anpassung an das jeweilige Cluster eine große Variation des Konvertereingangsspannungsbereichs für eine oder mehrere gemeinsame Ausgangsspannungen. Moderne Konverterelektronik erlaubt einen breiteren Konvertereingangsspannungsbereich bei jedem einzelnen Spannungskonverter, was gemeinsam mit seiner Lage unmittelbar am Cluster den Arbeitsbereich des Clusters erweitert und seinen individuell optimalen Betrieb ermöglicht, z.B. durch lokale und einzelne Regelung, dadurch z.B. auch angepasst an unebene Montageflächen, und somit mehr Ertrag erbringt.

In einer weiteren vorteilhaften Ausführungsform ist es für jeden Spannungskonverter einzeln möglich zu wählen, ob der Stromkreis des höheren Spannungsbereichs an seinem Ausgang von der niedrigen Spannung des Photovoltaikclusters an der Eingangsseite getrennt werden soll oder nicht. Die Trennung kann galvanisch oder nichtgalvanisch erfolgen. Galvanische Trennung kann erreicht werden durch eine geeignete Wahl der Konvertertopologie, beispielsweise durch die Verwendung eines isolierenden Transformators als Induktivität im Spannungskonverter oder durch kapazitive Ladungspumpen, wobei hierbei der Wirkungsgrad im Vergleich zu einer sonst gleichen, nicht-isolierenden Ausführung geringfügig niedriger ausfällt. Durch geeignete Wahl des Nullniveaus zwischen den Extremspannungen an der Konverterausgangsseite, d.h. beispielsweise durch die Wahl von -300V bis +300V und damit nur noch 300V gegenüber metallischen Strukturteilen anstelle von 0V bis 600V, kann das Überschlagsrisiko auf den langen Leitungswegen vom Generator und auch zentral auf Seiten des Satelliten zusätzlich reduziert werden.

Eine Trennung der hohen Spannung an der Ausgangsseite des Spannungskonverters von der niedrigen Spannung des Photovoltaikclusters an der Eingangsseite, z.B. zum Schutze derselben, ist auch bei nicht-isolierender Konvertertopologie sicher möglich. In einer weiteren vorteilhaften Ausführungsform wird hierzu die in geeigneten Konvertertopologien bereits vorhandene Ausgangsgleichrichterdiode verwendet. Der anteilige Leistungsverlust an dieser Diode, die somit auch gleichzeitig als Sicherheitsbauteil wirkt, etwa anstelle der Stringdiode des Standes der Technik tritt, wird gegenüber dieser drastisch reduziert.

Ein erfinderisches Verfahren zum Betreiben einer Vorrichtung zur Umwandlung von Licht in elektrische Energie für einen Satelliten, wobei die Vorrichtung wenigstens ein Cluster aufweist, welches mit wenigstens einem Photovoltaikmodul oder einer Verschaltung solcher bestückt ist, welches wiederum mit wenigstens einer Photovoltaikzelle oder einer Verschaltung solcher ausgestattet ist, wobei der Cluster einen Spannungskonverter aufweist, ist dadurch gekennzeichnet, dass jeder Cluster an seinem individuellen optimalen Arbeitspunkt betrieben wird. Der optimale Arbeitspunkt eines Photovoltaikmoduls ist temperaturabhängig, beleuchtungsabhängig und lastabhängig. Die Temperatur kann über der Fläche eines Photovoltaikgenerators erheblich variieren. Da jedes Cluster unabhängig von anderen Clustern betrieben werden kann, kann jedes Photovoltaikmodul ebenfalls unabhängig von anderen Photovoltaikmodulen an einem anderen Arbeitspunkt betrieben werden.

In einem vorteilhaften Ausführungsbeispiel wird eine verhältnismäßig viel höhere Sekundärspannung, z.B. 600V oder mehr bei einer Primärspannung von beispielsweise 20 V oder weniger, in einem Konversions-Schritt direkt auf dem Photovoltaikgenerator erzeugt. Insbesondere können die von großen elektrischen Triebwerken genutzten Spannungen in einem Konversions-Schritt direkt auf dem Generator erzeugt werden. Die kleinere Bauform und Masse von Spannungskonvertern, die nur ein Cluster bedienen, ermöglicht auch die dezentrale Verwendung solcher Konverterelektroniken, die größere Sekundärspannungen in Größenordnung bis zu mehreren Hundert Volt und sogar weit darüber hinaus ermöglichen.

Ein erfinderisches Energieerzeugungssystem eines Satelliten weist einen Solargenerator mit der erfindungsgemäßen Vorrichtung und ein flächiges Trägerpaneel, das die photoelektrischen Komponenten trägt und mit dem Satelliten verbindet, mit einer ersten und einer zweiten Flächenseite auf und ist dadurch gekennzeichnet, dass auf der ersten Flächenseite eine Mehrzahl Cluster aufweisend Photovoltaikmodulen unterschiedlicher Größe angeordnet ist, wobei innerhalb eines Clusters für einen optimalen Ertrag jede Teilverschaltung von Solarzellen gleichartig aufeinander abgestimmt ist, und jedem Cluster nur ein Spannungskonverter zugeordnet ist.

In einer vorteilhaften Ausführungsform ist der Spannungskonverter auf der zweiten Flächenseite des Solarpaneels angeordnet. Ist die erste Flächenseite des Solarpaneels die der Sonne zugewandte Fläche und die zweite Flächenseite des Solarpaneels die der Sonne abgewandte Fläche, so wird durch die Anordnung des Spannungskonverters auf der zweiten Flächenseite des Solarpaneels Fläche auf der ersten Flächenseite des Solarpaneels eingespart, die für weitere Photovoltaikmodule verwendet werden kann. Darüber hinaus führt diese Anordnung zu thermischen Vorteilen bei dem Spannungskonverter, da dieser auf der nicht direkt beleuchteten, kühleren Seite des Solarpaneels angeordnet ist.

In einer alternativen Ausführungsform ist der Spannungskonverter zwischen den Photovoltaikzellen angeordnet.

Bei Satelliten gilt generell, dass sie zur Kostenersparnis hinsichtlich der Startkosten möglichst leicht sein müssen. Unnötige Masse muss generell, eben auch bei Photovoltaikgeneratoren und den erforderlichen Stromleitungen, vermieden werden. Darüber hinaus sind Photovoltaikgeneratoren in der Regel auf ausklappbaren oder anderweitig entfaltbaren Solarpaneelen angeordnet, wodurch Masseeinsparungen auf den Solarpaneelen wegen der für die Lagekontrolle der Solarpaneele wichtigen Massenträgheitsmomente weitere Vorteile bieten. Schwerere Solarpaneele erfordern leistungsfähigere Lagekontrollsysteme, was wiederum höhere Kosten und einen noch höheren elektrischen Energiebedarf verursacht.

Ein wesentlicher Beitrag zur Photovoltaikgeneratorenmasse ist die Masse der Stromleitungen auf den Solarpaneelen. Die Masse der Stromleitungen hängt von den erforderlichen Leitungsquerschnitten und diese wiederum von den zu transportierenden elektrischen Strömen ab. Dieselbe elektrische Leistung kann sowohl bei niedriger Spannung und hohem Strom als auch bei hoher Spannung und eher kleinem Strom geführt werden. Die auf dem Photovoltaikgenerator verwendbare Spannung hat also über den zugehörigen Strom direkte Auswirkung auf die Leitungsquerschnitte und damit auf die Masse. Höhere Spannungen auf den Solarpaneelen sind also grundsätzlich von Vorteil. Im Stand der Technik werden Spannungskonverter jedoch nur zentral im Satelliten und nicht dezentral auf den Photovoltaikgeneratoren verwendet. Dadurch können höhere Spannungen im Bereich des Solarpaneels im Prinzip nur durch Vergrößerung der Anzahl der in den Photovoltaikmodulen in Reihe geschalteten Zellen, der Strings generiert werden. Dies ist aber durch das Überschlagsrisiko begrenzt und erschwert gleichzeitig das Problem der Flächennutzung signifikant durch die deutlich größeren untrennbaren Inkremente, d.h. lange Strings, in der Flächenaufteilung. Masseeinsparung bei den elektrischen Leitungen ist dadurch nur sehr eingeschränkt möglich.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildung.

Von den Abbildungen zeigt:

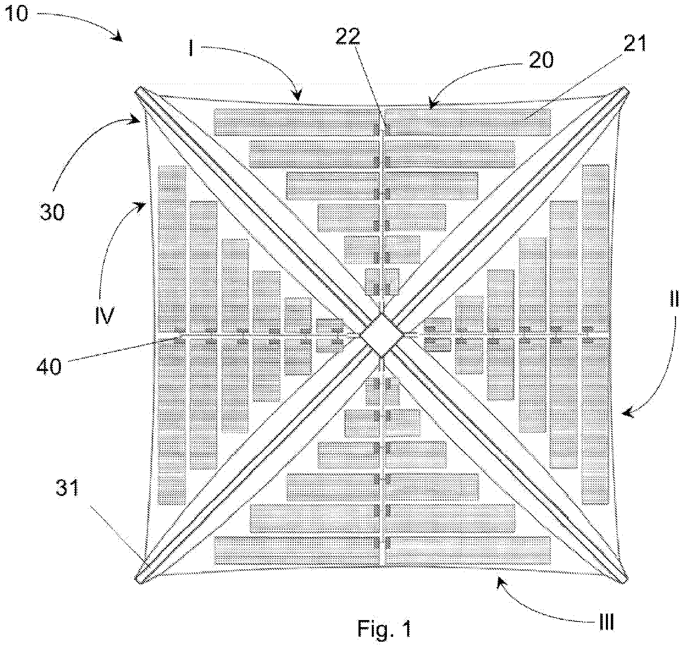

Fig. 1 Entfaltbares Solarpaneel 30 mit Clustern 20

Fig. 1 zeigt ein entfaltbares Solarpaneel 30 ähnlich einem Gossamer-1-Demonstrator, bei dem eine mit Dünnfilmphotovoltaikmodulen belegte Fläche als leichter, entfaltbarer Photovoltaikgenerator verwendet wird. Die Cluster 20 an sich sind der Übersichtlichkeit halber mit nur jeweils einem Photovoltaikmodul 21 je Cluster ausgestattet dargestellt. (Auf eine Untergliederung in Photovoltaikmodule 21 innerhalb eines Clusters 20 wurde aus Gründen der Übersichtlichkeit verzichtet.) Die hier beschriebene Anordnung ist auf beliebige Formen von Solargeneratoren sinngemäß anwendbar. Ein Satellit kann mehrere Solarpaneele 30 aufweisen. Das Solarpaneel 30 weist vier dreieckige Segelsegmente I, II, III, IV auf und ist einklappbar ausgestaltet. Dargestellt ist die Draufsicht auf die der Sonne zugewandte erste Flächenseite im entfalteten bzw. ausgeklappten Zustand. Die zur Verfügung stehenden Flächen der vier dreieckigen Segelsegmente I, II, III, IV sind der gezeigten rechteckigen Cluster-Form nach zum maximalen Flächenanteil mit Clustern 20 belegt, wobei jeder Cluster 20 eine Mehrzahl von verschalteten Photovoltaikmodulen 21 aufweisen kann (in der Abbildung der Übersichtlichkeit halber nur ein Photovoltaikmodul dargestellt), wobei jedem Cluster 20 nur ein Spannungskonverter 22 zugeordnet ist. Jedes der vier Segelsegmente I, II, III, IV ist hier mit zwölf Clustern 20 in 6 unterschiedlichen Größen belegt. Die verfügbare Fläche ist mit deutlich unterschiedlich langen Photovoltaikmodulen 21 ausgefüllt. Von jedem Spannungskonverter 22 führt ein Kabel 40 entlang der Mittelachse eines jeden Segelsegments I, II, III, IV zum Satelliten. Dabei spielt es keine Rolle, ob die Kabel 40 für die einzelnen Spannungskonverter 22 insgesamt oder in Gruppen (ggf. unterschiedlicher Ausgangsspannungen) zusammengefasst sind oder einzeln geführt werden, da der erforderliche Leitungsquerschnitt (ggf. für jedes Ausgangsspannungsniveau) in der Summe derselbe bleibt. Aufgrund einer geeignet gewählten und für alle Cluster 20 gleichen Sekundärspannung von zum Beispiel 600V kann ein relativ dünnes, massesparendes Kabel 40 verwendet werden.

Die hier gezeigten Ausführungsformen stellen nur Beispiele für die vorliegende Erfindung dar und dürfen daher nicht einschränkend verstanden werden. Alternative durch den Fachmann in Erwägung gezogene Ausführungsformen sind gleichermaßen vom Schutzbereich der vorliegenden Erfindung umfasst, welcher durch die vorliegenden Ansprüche bestimmt wird.

## Patentansprüche

1. Vorrichtung (10) zur Umwandlung von Licht in elektrische Energie für einen Satelliten, aufweisend einen oder mehrere Cluster (20) mit einem oder einer Mehrzahl von Photovoltaikmodulen (21) mit in Reihe geschalteten einzelnen Photovoltaikzellen und weiterhin aufweisend einen Spannungskonverter (22), wobei jedem Cluster (20) genau ein Spannungskonverter (22) zugeordnet ist, wobei die Vorrichtung (10) mehrere Cluster (20) aufweist,
**dadurch gekennzeichnet,**
**dass** die mehreren Cluster (20) unterschiedliche Größen aufweisen, wobei der Spannungskonverter (22) unmittelbar an einer Photovoltaikzelle angeordnet oder direkt in einer Photovoltaikzelle integriert ist.

2. Vorrichtung (10) gemäß Anspruch 1,
**dadurch gekennzeichnet,**
**dass** jeder Cluster (20) zusammen mit dem diesem Cluster (20) zugeordneten Spannungskonverter (22) auf jeweils genau einem Solarpaneel (30) angeordnet ist.

3. Vorrichtung (10) gemäß Anspruch 1,
**dadurch gekennzeichnet,**
**dass** ein Cluster (20) auf mehrere Solarpaneele (30) aufgeteilt ist.

4. Vorrichtung (10) gemäß einem der vorherigen Ansprüche,
**dadurch gekennzeichnet,**
**dass** für jeden Spannungskonverter (22) einzeln eine Trennung des Stromkreises des höheren Spannungsbereichs an seinem Ausgang vom Rest der Vorrichtung (10) wählbar ist.

5. Vorrichtung (10) gemäß Anspruch 4,
**dadurch gekennzeichnet,**
**dass** die Trennung des Stromkreises des höheren Spannungsbereichs an dem Ausgang eines jeden Spannungskonverters (22) vom Rest der Vorrichtung (10) als galvanische Trennung ausgeführt ist.

6. Vorrichtung (10) gemäß einem der vorherigen Ansprüche,
**dadurch gekennzeichnet,**
**dass** eine Trennung des Stromkreises des höheren Spannungsbereichs an dem Ausgang eines jeden Spannungskonverters (22) von der niedrigen Spannung des Clusters (20) an der Eingangsseite des Spannungskonverters (22) als nichtgalvanische Trennung ausgeführt ist.

7. Verfahren zum Betreiben einer Vorrichtung (10) zur Umwandlung von Licht in elektrische Energie für einen Satelliten gemäß den Ansprüchen 1-6, wobei die Vorrichtung (10) wenigstens ein Cluster (20) mit wenigstens einem Photovoltaikmodul (21) oder einer Verschaltung von Photovoltaikmodulen (21) aufweist, wobei der Cluster einen Spannungskonverter (22) aufweist,
**dadurch gekennzeichnet,**
**dass** jeder Cluster (20) an seinem individuellen optimalen Arbeitspunkt betrieben wird.

8. Verfahren gemäß Anspruch 7,
**dadurch gekennzeichnet,**
**dass** eine Sekundärspannung durch Konversions-Schritte direkt auf dem Photovoltaikgenerator (10) erzeugt wird.

9. Energieerzeugungssystem (30) eines Satelliten, aufweisend einen Solargenerator mit einer Vorrichtung (10) gemäß einem der Ansprüche 1 bis 6 und ein flächiges Trägerpaneel (32) mit einer ersten und einer zweiten Flächenseite,
**dadurch gekennzeichnet,**
**dass** auf der ersten Flächenseite eine Mehrzahl Cluster (21) aufweisend Photovoltaikmodule (21) unterschiedlicher Größe angeordnet ist, wobei innerhalb eines Clusters (21) für einen optimalen Ertrag jede Teilverschaltung von Solarzellen gleichartig aufeinander abgestimmt ist, und jedem Cluster (21) nur ein Spannungskonverter (22) zugeordnet ist.

10. Energieerzeugungssystem (30) eines Satelliten gemäß Anspruch 9,
**dadurch gekennzeichnet,**
**dass** der Konverter (22) auf der zweiten Flächenseite des Solarpaneels (30) angeordnet ist.

11. Energieerzeugungssystem (30) eines Satelliten gemäß Anspruch 9,
**dadurch gekennzeichnet,**
**dass** der Spannungskonverter (22) zwischen den Photovoltaikzellen angeordnet ist.

## Claims

1. Apparatus (10) for converting light into electrical energy for a satellite, comprising one or more clusters (20) with one or a plurality of photovoltaic modules (21) with individual serially switched photovoltaic cells, and further comprising a voltage converter (22), with exactly one voltage converter (22) being allocated to each cluster (20), with the apparatus (10) comprising several clusters (20),
**characterized in that**
the several clusters (20) have different sizes, the voltage converter (22) being arranged directly at a photovoltaic cell or integrated directly in a photovoltaic cell.

2. Apparatus (10) according to Claim 1,
**characterized in that**
each cluster (20) is arranged, together with the voltage converter (22) allocated to this cluster (20), on exactly one solar panel (30) .

3. Apparatus (10) according to Claim 1,
**characterized in that**
one cluster (20) is divided over several solar panels (30).

4. Apparatus (10) according to one of the above Claims,
**characterized in that**
for each voltage converter (22) individually, a disconnection of the power circuit of the higher voltage range at its output from the rest of the apparatus (10) can be selected.

5. Apparatus (10) according to Claim 4,
**characterized in that**
the disconnection of the power circuit of the higher voltage range at the output of each voltage converter (22) from the rest of the apparatus (10) is embodied as a galvanic separation.

6. Apparatus (10) according to one of the above Claims,
**characterized in that**
a disconnection of the power circuit of the higher voltage area at the output of each voltage converter (22) from the lower voltage of the cluster (20) at the input side of the voltage converter (22) is embodied as a non-galvanic separation.

7. Method of operating an apparatus (10) for converting light into electrical energy for a satellite according to Claims 1-6, the apparatus (10) comprising at least one cluster (20) with at least one photovoltaic module (21) or a circuitry of photovoltaic modules (21), the cluster comprising a voltage converter (22),
**characterized in that**
each cluster (20) is operated at its individual optimal operating point.

8. Method according to Claim 7,
**characterized in that**
a secondary voltage is generated by conversion steps directly on the photovoltaic generator (10).

9. Energy production system (30) of a satellite, comprising a solar generator with an apparatus (10) according to one of Claims 1 through 6 and a planar carrier panel (32) with a first and a second surface side,
**characterized in that**
on the first surface side, a plurality of clusters (21) having photovoltaic modules (21) of different sizes are arranged, where for optimum yield, within one cluster (21), each partial circuitry of solar cells is homogeneously matched and only one voltage converter (22) is allocated to each cluster (21).

10. Energy production system (30) of a satellite according to Claim 9,
**characterized in that**
the converter (22) is arranged on the second surface side of the solar panel (30).

11. Energy production system (30) of a satellite according to Claim 9,
**characterized in that**
the voltage converter (22) is arranged between the photovoltaic cells.

## Revendications

1. Dispositif (10) de conversion de lumière en énergie électrique pour un satellite, comportant un ou plusieurs ensembles groupés (20) avec un module photovoltaïque ou une pluralité de modules photovoltaïques (21) avec des cellules photovoltaïques individuelles connectées en série et comportant en plus un convertisseur de tension (22), sachant qu'à chaque ensemble groupé (20) est attribué exactement un convertisseur de tension (22), sachant que le dispositif (10) comporte plusieurs ensembles groupés (20),
**caractérisé en ce que**
les nombreux ensembles groupés (20) comportent des tailles différentes, sachant que le convertisseur de tension (22) est directement disposé sur une cellule photovoltaïque ou est intégré directement dans une cellule photovoltaïque.

2. Dispositif (10) selon la revendication 1,
**caractérisé en ce que**
chaque ensemble groupé (20) ensemble avec le convertisseur de tension (22) attribué à cet ensemble groupé (20) est respectivement disposé exactement sur un panneau solaire (30).

3. Dispositif (10) selon la revendication 1,
**caractérisé en ce qu'**
un ensemble groupé (20) est réparti sur plusieurs panneaux solaires (30).

4. Dispositif (10) selon l'une quelconque des revendications précédentes,
**caractérisé en ce que**
pour chaque convertisseur de tension (22), une séparation du circuit de courant de la plage de tension plus élevée peut être sélectionnée individuellement à sa sortie du reste du dispositif (10).

5. Dispositif (10) selon la revendication 4,
**caractérisé en ce que**
la séparation du circuit de courant de la plage de tension plus élevée à la sortie de chaque convertisseur de tension (22) du reste du dispositif (10) est exécutée en tant que séparation galvanique.

6. Dispositif (10) selon l'une quelconque des revendications précédentes,
**caractérisé en ce qu'**
à la sortie de chaque convertisseur de tension (22), une séparation du circuit de courant de la plage de tension plus élevée de la tension basse de l'ensemble groupé (20) sur le côté d'entrée du convertisseur de tension (22) est exécutée en tant que séparation non galvanique.

7. Procédé destiné à faire fonctionner un dispositif (10) pour la conversion de lumière en énergie électrique pour un satellite selon les revendications 1-6, sachant que le dispositif (10) comporte au moins un ensemble groupé (20) avec au moins un module photovoltaïque (21) ou une interconnexion de modules photovoltaïques (21), sachant que l'ensemble groupé comporte un convertisseur de tension (22),
**caractérisé en ce que**
chaque ensemble groupé (20) est utilisé à son point de travail individuel optimal.

8. Procédé selon la revendication 7,
**caractérisé en ce qu'**
une tension secondaire est produite par des étapes de conversion directement sur le générateur photovoltaïque (10) .

9. Système de production d'énergie (30) d'un satellite comportant un générateur solaire avec un dispositif (10) selon l'une quelconque des revendications 1 à 6 et un panneau de support plat (32) avec une première et une deuxième face,
**caractérisé en ce que**
sur la première face est disposée une pluralité d'ensembles groupés (21) comportant des modules photovoltaïques (21) de taille différente, sachant qu'à l'intérieur d'un ensemble groupé (21) pour un rendement optimal, chaque interconnexion partielle de cellules solaires est ajustée de façon identique l'une sur l'autre et seulement un convertisseur de tension (22) est attribué à chaque ensemble groupé (21).

10. Système de production d'énergie (30) d'un satellite selon la revendication 9,
**caractérisé en ce que**
le convertisseur (22) est disposé sur la deuxième face du panneau solaire (30).

11. Système de production d'énergie (30) d'un satellite selon la revendication 9,
**caractérisé en ce que**
le convertisseur de tension (22) est disposé entre les cellules photovoltaïques.
